# EUROPEAN PATENT APPLICATION

(11) **EP 4 407 679 A2**
(43) Date of publication of application: **31.07.2024**
(21) Application number: 24154291.9
(22) Date of filing: 26.01.2024
(51) Int. Cl.: H01L 25/065, H01L 25/18

(54) **INTEGRATED CIRCUIT DEVICE WITH STACKED INTERFACE CHIPLETS**

(30) Priority: 26.01.2023 US 202363441431 P
(71) Applicant: Marvell Asia Pte, Ltd., Singapore 369522 (SG)
(72) Inventor: CHAKRAVARTI, Aatreya, Williston, 05495 (US); KUEMERLE, Mark William, Essex Junction, 05452 (US); SAUTER, Wolfgang, Starksboro, 05487 (US); MACIAN RUIZ, Carlos, Los Gatos, 95032 (US); GREGORY, Jr. John Edward, Dummerston, 05301 (US); HOLMES, Eva Shah, Wappingers Falls, 12590 (US); AKIKI, Samer Michael, San Diego, 92131 (US)
(74) Representative: Haley Guiliano International LLP

(57) **Abstract**

An integrated circuit device includes a main integrated circuit die having functional circuitry configured to communicate over a network through one or more high-speed communications interfaces, and at least one secondary integrated circuit die including serial interface circuitry. Each integrated circuit die among the at least one secondary integrated circuit die is mounted on a first surface of the main integrated circuit die, and first metallization connections extend along one or more first through-silicon vias between the functional circuitry and the serial interface circuitry of the at least one secondary integrated circuit die. The first metallization connections may be configured to provide data from the main die to the secondary die, and the secondary die may be configured to communicate data between the integrated circuit device and a remote integrated circuit device. Second metallization connections extend between the serial interface circuitry of and terminals of the main integrated circuit die.

## Description

### Cross Reference to Related Application

This disclosure claims the benefit of copending, commonly-assigned United States Provisional Patent Application No. 63/441,431, filed January 26, 2023, which is hereby incorporated by reference herein in its entirety.

### Field of Use

This disclosure relates to input/output structures for integrated circuit devices. More particularly, this disclosure relates to integrated circuit device packages in which serializer/deserializer (SerDes) chiplets are stacked on the main integrated circuit die.

### Background

The background description provided herein is for the purpose of generally presenting the context of the disclosure. Work of the inventors hereof, to the extent the work is described in this background section, as well as aspects of the description that may not otherwise qualify as prior art at the time of filing, are neither expressly nor impliedly admitted to be prior art against the subject matter of the present disclosure.

An integrated circuit device may use serial signaling for communicating with off-chip devices, including other integrated circuit devices. SerDes interfaces may be included onboard an integrated circuit device to provide the serial signaling capability. As signaling speeds increase, the size and power requirements for SerDes interfaces consume an ever-greater share of integrated circuit device area, even as more area is needed for the functional circuitry of the main die of the integrated circuit device itself. Moving the SerDes interfaces into separate chiplets in the same package, that communicate with the main die via, e.g., extremely short reach (XSR) interfaces, increases the area available on the main die for the functional circuitry, but consumes valuable die "beachfront" for the XSR interfaces, which also consume substantial power.

### Summary

According to implementations of the subject matter of this disclosure, an integrated circuit device includes a main integrated circuit die having functional circuitry configured to communicate over a network through one or more high-speed communications interfaces, at least one secondary integrated circuit die including serial interface circuitry, each secondary integrated circuit die among the at least one secondary integrated circuit die being mounted on a first surface of the main integrated circuit die, and first metallization connections extending along one or more first through-silicon vias between the functional circuitry and the serial interface circuitry of the at least one secondary integrated circuit die.

In a first implementation of such an integrated circuit device, the first metallization connections may be configured to provide data from the main integrated circuit die to the secondary integrated circuit die, and the secondary integrated circuit die may be configured to communicate data between the integrated circuit device and a remote integrated circuit device.

A second implementation of such an integrated circuit device may further include second metallization connections between the serial interface circuitry of the at least one secondary integrated circuit die and terminals of the main integrated circuit die.

According to a first aspect of that second implementation, at least one metallization connection among the first metallization connections may extend along a respective one of the first through-silicon vias between (a) elements of the functional circuitry within layers of the main integrated circuit die, and (b) the first surface of the main integrated circuit die.

In a first instance of that first aspect, at least one metallization connection among the second metallization connections may extend along at least one respective second through-silicon via between (a) the first surface of the main integrated circuit die, and (b) at least one respective terminal of the main integrated circuit die, the at least one respective second through-silicon via being perpendicular to the first surface of the main integrated circuit die.

In a first variation of that first instance, the at least one metallization connection among the first metallization connections may extend along a respective first through-silicon via, parallel to the first surface of the main integrated circuit die, between respective ones of the at least one second through-silicon via, to reach the functional circuitry.

According to a second aspect of that second implementation, at least one metallization connection among the second metallization connections may extend along at least one respective second through-silicon via between (a) the first surface of the main integrated circuit die, and (b) at least one respective terminal of the main integrated circuit die.

In a first instance of that second aspect, the respective one of the terminals of the main integrated circuit die may be on a second surface of the main integrated circuit die opposite the first surface of the main integrated circuit die.

In a second instance of that second aspect, the at least one secondary integrated circuit die may be mounted on the first surface of the main integrated circuit die in a contact relationship with the respective second through-silicon via.

In a first variation of that second instance, the at least one metallization connection among the second metallization connections may extend from the serial interface circuitry of the at least one secondary integrated circuit die along the respective second through-silicon via between (a) the first surface of the main integrated circuit die, and (b) the at least one respective terminal of the main integrated circuit die, without any external connection channel extending between the serial interface circuitry of the at least one secondary integrated circuit die and the at least one respective terminal.

In a third instance of that second aspect, the at least one secondary integrated circuit die may be mounted on the first surface of the main integrated circuit die at a distance from the respective second through-silicon via, and the at least one metallization connection among the second metallization connections includes a metallization trace from the at least one secondary integrated circuit die to the respective second through-silicon via.

In a fourth instance of that second aspect, the main integrated circuit die may have a plurality of the respective second through-silicon vias, second through-silicon vias in the plurality of the respective second through-silicon vias may be grouped into respective zones, the second through-silicon vias being distributed at different areal densities in different zones, the at least one secondary integrated circuit die including serial interface circuitry may include a plurality of respective integrated circuit dies each having respective serial interface circuitry of different respective maximum speeds, and respective ones of the second metallization connections couple the respective serial interface circuitry of each respective secondary integrated circuit die of the plurality of secondary integrated circuit dies to at least one of the second through-silicon vias in one of the respective zones according to the respective maximum speed of the respective serial interface circuitry.

In a fifth instance of that second aspect, the main integrated circuit die may further include additional interface circuitry coupled to particular terminals of the main integrated circuit die, the at least one metallization connection among the second metallization connections, that extends along the at least one respective second through-silicon via between (a) the first surface of the main integrated circuit die, and (b) the at least one respective terminal of the main integrated circuit die, may extend along the at least one respective second through-silicon via between (a) the first surface of the main integrated circuit die, and (b) the particular terminals of the main integrated circuit die, and when the additional interface circuitry is not being used, the second metallization connections may be used to connect the at least one secondary integrated circuit die through the at least one respective second through-silicon via to the particular terminals of the main integrated circuit die.

In accordance with implementations of the subject matter of this disclosure, a method of forming an integrated circuit device, having a main integrated circuit die having functional circuitry configured to communicate over a network through one or more high-speed communications interfaces, includes mounting, on a first surface of the main integrated circuit die, at least one secondary integrated circuit die including serial interface circuitry, and creating first metallization connections extending along one or more first through-silicon vias between the functional circuitry and the serial interface circuitry of the at least one secondary integrated circuit die.

A first implementation of such a method may further include configuring the first metallization connections to provide data from the main integrated circuit die to the secondary integrated circuit die, and configuring the secondary integrated circuit die to communicate data between the integrated circuit device and a remote integrated circuit device.

A second implementation of such a method may further include creating second metallization connections between the serial interface circuitry of the at least one secondary integrated circuit die and terminals of the main integrated circuit die.

According to a first aspect of that second implementation, creating the first metallization connections may include creating at least one metallization connection among the first metallization connections extending along a respective of the first through-silicon vias between (a) elements of the functional circuitry within layers of the main integrated circuit die, and (b) the first surface of the main integrated circuit die.

In a first instance of that first aspect, creating the second metallization connections may include creating at least one metallization connection among the second metallization connections extending along at least one respective second through-silicon via between (a) the first surface of the main integrated circuit die, and (b) at least one respective terminal of the main integrated circuit die, the at least one respective second through-silicon via being perpendicular to the first surface of the main integrated circuit die.

In a first variation of that first instance, creating the first metallization connections may include creating at least one metallization connection among the first metallization connections that extends along a respective first through-silicon via, parallel to the first surface of the main integrated circuit die, between respective ones of the at least one second through-silicon via, to reach the functional circuitry.

According to a second aspect of that second implementation, creating the second metallization connections may include creating at least one metallization connection among the second metallization connections extending along at least one respective second through-silicon via between (a) the first surface of the main integrated circuit die, and (b) at least one respective terminal of the main integrated circuit die.

In a first instance of that second aspect, creating the at least one metallization connection among the second metallization connections extending along the at least one respective second through-silicon via between (a) the first surface of the main integrated circuit die, and (b) at least one respective terminal of the main integrated circuit die may include creating the at least one metallization connection among the second metallization connections extending along the at least one respective second through-silicon via between (a) the first surface of the main integrated circuit die, and (b) at least one respective terminal of the main integrated circuit die on a second surface of the main integrated circuit die opposite the first surface of the main integrated circuit die.

In a second instance of that second aspect, mounting, on the first surface of the main integrated circuit die, the at least one secondary integrated circuit die including serial interface circuitry, may include mounting the at least one secondary integrated circuit die on the first surface of the main integrated circuit die in a contact relationship with the respective second through-silicon via.

In a first variation of that second instance, creating the at least one metallization connection among the second metallization connections extending from the serial interface circuitry of the at least one secondary integrated circuit die along the respective second through-silicon via between (a) the first surface of the main integrated circuit die, and (b) the at least one respective terminal of the main integrated circuit die, may include creating the at least one metallization connection among the second metallization connections extending from the serial interface circuitry of the at least one secondary integrated circuit die along the respective second through-silicon via between (a) the first surface of the main integrated circuit die, and (b) the at least one respective terminal of the main integrated circuit die without creating any external connection channel extending between the serial interface circuitry of the at least one secondary integrated circuit die and the at least one respective terminal.

In a third instance of that second aspect, mounting, on the first surface of the main integrated circuit die, the at least one secondary integrated circuit die including serial interface circuitry, may include mounting the at least one secondary integrated circuit die on the first surface of the main integrated circuit die at a distance from the respective second through-silicon via, and the method may further include creating a metallization trace from the at least one secondary integrated circuit die to the respective second through-silicon via.

In a fourth instance of that second aspect, mounting, on the first surface of the main integrated circuit die, the at least one secondary integrated circuit die including serial interface circuitry, may include mounting a plurality of respective integrated circuit dies each having respective serial interface circuitry of different respective maximum speeds, and the method may further include forming a plurality of the respective through-silicon vias in the main integrated circuit die, grouping second through-silicon vias in the plurality of the respective second through-silicon vias into respective zones, and distributing the second through-silicon vias at different areal densities in different zones, and coupling the respective serial interface circuitry of each respective secondary integrated circuit die of the plurality of secondary integrated circuit dies to at least one of the second through-silicon vias in one of the respective zones according to the respective maximum speed of the respective serial interface circuitry.

In a fifth instance of that second aspect, when the main integrated circuit die further includes additional interface circuitry coupled to particular terminals of the main integrated circuit die, forming the at least one metallization connection among the second metallization connections, that extends along the at least one respective second through-silicon via between (a) the first surface of the main integrated circuit die, and (b) the at least one respective terminal of the main integrated circuit die, may include forming the at least one metallization connection among the second metallization connections to extend along the at least one respective second through-silicon via between (a) the first surface of the main integrated circuit die, and (b) the particular terminals of the main integrated circuit die, and when the additional interface circuitry is not being used, using the second metallization connections to connect the at least one secondary integrated circuit die through the at least one respective second through-silicon via to the particular terminals of the main integrated circuit die.

### Brief Description of the Drawings

Further features of the disclosure, its nature and various advantages, will be apparent upon consideration of the following detailed description, taken in conjunction with the accompanying drawings, in which like reference characters refer to like parts throughout, and in which:
FIG. 1 shows a first implementation of an integrated circuit device incorporating the subject matter of this disclosure;
FIG. 2 shows a second implementation of an integrated circuit device incorporating the subject matter of this disclosure;
FIG. 3 shows one implementation of how through-silicon vias (TSVs) may be distributed on a main integrated circuit die to facilitate signaling between circuitry of the die and chiplets mounted on a surface of the die;
FIG. 4 shows one implementation of how SerDes chiplets may be mounted on a main integrated circuit die;
FIG. 5 shows a first variation of the implementation of FIG. 4;
FIG. 6 shows a second variation of the implementation of FIG. 4;
FIG. 7 shows another implementation of the distribution of chiplets and through-silicon vias on an integrated circuit die;
FIG. 8 shows yet another implementation of the distribution of a chiplet and through-silicon vias on an integrated circuit die;
FIG. 9 show how functional circuitry of an integrated circuit die can be coupled through chiplets mounted on the integrated circuit die to terminals of an integrated circuit device;
FIG. 10 shows an implementation of how through-silicon vias may extend in different directions through an integrated circuit die; and
FIG. 11 is a flow diagram illustrating an implementation of a method in accordance with the subject matter of this disclosure.

### Detailed Description

As noted above, an integrated circuit device may use serial signaling for communicating with off-chip devices, including other integrated circuit devices. SerDes interfaces may be included onboard an integrated circuit device to provide the serial signaling capability. As signaling speeds increase, the size and power requirements for SerDes interfaces consume an ever-greater share of integrated circuit device area, even as more area is needed for the functional circuitry of the main die of the integrated circuit device itself. Moving the SerDes interfaces into separate chiplets in the same package, on the same substrate as the main die, and that communicate with the main die via, e.g., XSR interfaces, increases the area available on the main die for the functional circuitry, but consumes valuable die "beachfront" for the XSR interfaces, which also consume substantial power. This may be of particular concern when the integrated circuit device is used in an application that experiences high throughput, such as a network switch or an artificial intelligence/ machine-learning (AI/ML) engine.

In accordance with implementations of the subject matter of this disclosure, SerDes interfaces in separate chiplets in the same package are mounted, not on the same substrate as the main die (which could be called a "2D" arrangement), but rather stacked on an exterior surface of the main die itself (which could be called a "3D" arrangement). Stacking of the SerDes chiplets in direct contact with the surface of the main die allows communication between the main die circuitry and the SerDes interfaces without the need for power-hungry, space-consuming XSR interfaces. Instead, metal connections, such as traces or metallizations in a metal layer of the main die can provide any connections needed between the main die circuitry (e.g., without limitation, circuitry configured to communicate with one or more remote devices over a network through one or more high-speed communications interfaces, or AI/ML circuitry) and the SerDes interfaces. Similarly, connections between the interface circuitry and external device terminals can be made without any external connection channel extending between the interface circuitry of the external terminals.

In some implementations of the subject matter of this disclosure, the necessary metal connections can be made by way of through-silicon vias (TSVs) -- i.e., passages that are drilled, or otherwise formed, through the silicon (and metallization) layers of the die, and then coated or filled with metal to conduct signals. Some TSVs can extend completely through the die to connect circuitry in a SerDes chiplet directly to, e.g., a bump of a bump array on the opposite surface of the die for ultimate connection to a contact on the package exterior, such as a ball contact of a ball-grid array (BGA). Other TSVs may extend partway through the silicon to connect the SerDes with circuit elements of the main die functional circuitry. Still other TSVs may tunnel through the silicon (e.g., under other components) to reach pre-existing metal traces that connect to on-die components or to input/output pads. With the chiplets being stacked directly on the die, rather than adjacent the die (even on the same substrate), the TSVs can be short enough that they do not require the signal filtering or equalization that may be required with longer interconnections, including even XSR interconnections, and thus can considerably reduce power consumption requirements relative to SerDes configurations that necessitate signal filtering and equalization .

Various arrangements, including hybrid arrangements, of SerDes interfaces may be provided. Similarly, various arrangements of TSVs may be provided.

In a type of hybrid arrangement of SerDes interfaces, a first group (which may be referred to as a "ring") of SerDes interfaces may be provided off the main die on the substrate, and a second ring of SerDes interfaces may be stacked on the main die. In some of those hybrid arrangements, the SerDes interfaces in both rings may be identical, while in others of those hybrid arrangements the SerDes interfaces in one ring may be different from the SerDes interfaces in the other ring. For example, the SerDes interfaces stacked on the main die may be faster, or enable different length interconnections, than the SerDes interfaces in the outer ring on the substrate. The slower SerDes interfaces in the outer ring on the substrate may be used in applications where, in addition to their slower speeds being acceptable, the additional power consumed by, and the speed bottleneck attributable to, the XSR links to those outer-ring SerDes interfaces are tolerable. But if the faster stacked SerDes interfaces are to be used, having direct connections to those interfaces using TSVs allows the most advantage to be taken of those faster interfaces.

Different arrangements of TSVs also may be provided. For slower signals, regions of more densely packed TSVs may be provided, while for faster signals, regions of less densely packed TSVs may be provided. Indeed, different regions with more than two different densities of TSVs may be provided for a range of speeds. However, whatever TSVs are provided, care must be taken that when a TSV passes through the die, it does not impinge on active circuitry of the die. For a die with typical circuit layouts, there is normally sufficient room for TSVs without impinging on active circuitry.

If the different regions of TSVs are provided, for example, in an area near the periphery of the die, then in some implementations, the stacked SerDes interfaces could be stacked directly above the TSV regions, with the type of SerDes interface being matched to the type of TSV region. For example, faster SerDes interface chiplets could be stacked over areas of less densely packed TSVs, while slower SerDes interface chiplets could be stacked over areas of more densely packed TSVs. Alternatively, all of the SerDes chiplets could be stacked closer to the center of the die and away from the TSV regions at the edge of the die, with signal traces used to conduct signals from those SerDes chiplets to TSVs in the appropriate TSV regions.

In still other arrangements, there could be SerDes interfaces or other types of interfaces (e.g., physical layer transceivers) on the main die, coupled to input/output terminals (e.g., pins, pads or bumps) of the main die. If any of those onboard main-die interfaces are not used in a particular application (e.g., because a faster interface provided by a stacked SerDes chiplet is needed for the particular application), TSVs may be provided to tunnel through the die to conduct signals, from a SerDes interface that is stacked on the die, to the unused input/output terminals (whether they be pads, balls, bumps or other types of terminals) that that are not being used by the unused onboard main-die interface.

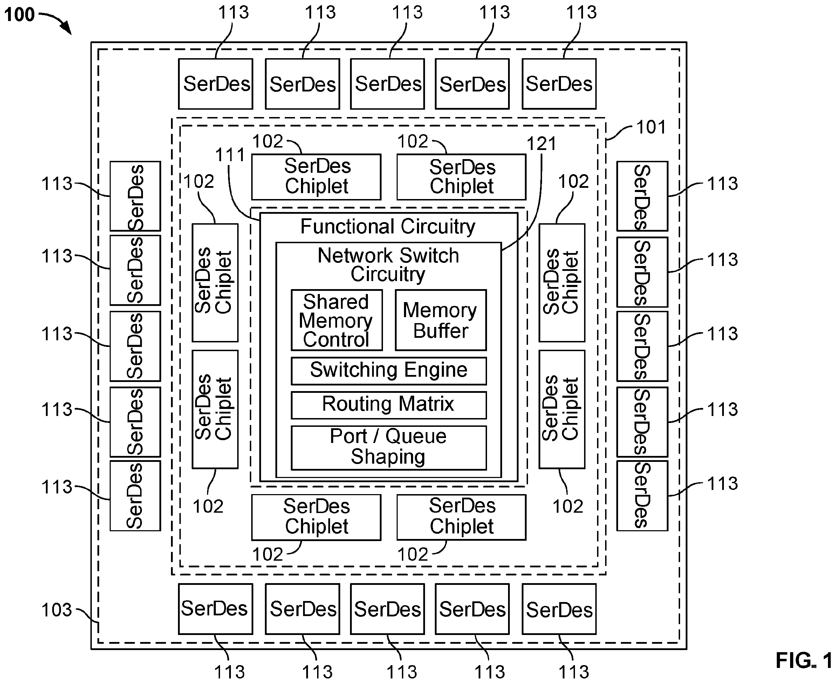

The subject matter of this disclosure may be better understood by reference to FIGS. 1-11.

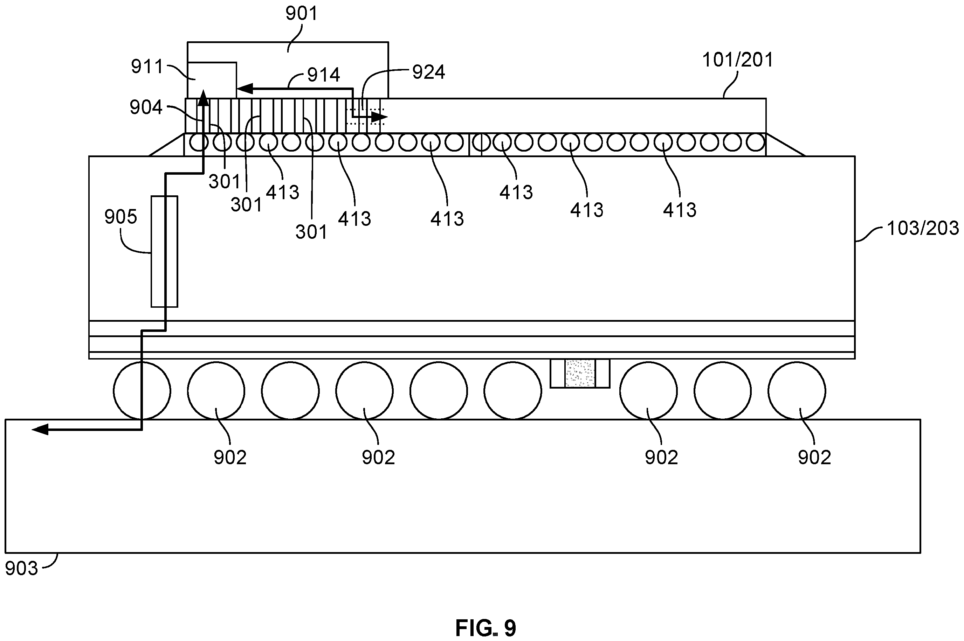

FIG. 1 shows a first implementation 100 of an integrated circuit device incorporating the subject matter of this disclosure. Integrated circuit device 100 includes a main integrated circuit die 101 incorporating functional circuitry 111. In this implementation, integrated circuit device 100 may be used for high-speed, high-bandwidth data transport in a network switch, and therefore functional circuitry 111 may include network switch circuitry 121 (including a memory buffer, shared memory control circuitry, a switching engine, a routing matrix, and port/queue shaping circuitry). A "ring" of chiplets 102, incorporating high-speed SerDes interfaces, are mounted on the surface of main integrated circuit die 101 near the edge. As described below in connection with FIG. 9, metallization connections are provided that are configured to provide data from main integrated circuit die 101 to high-speed SerDes interfaces of chiplets 102. The high-speed SerDes interfaces of chiplets 102 may be configured to communicate data between integrated circuit device 100 and a remote integrated circuit device (not shown).

Main integrated circuit die 101 is mounted on a laminate or substrate 103. In the implementation shown, additional SerDes interfaces 113 are mounted in an additional ring on laminate or substrate 103. SerDes interfaces 113 may be lower-speed SerDes interfaces that may be coupled to portions of functional circuitry 101 using, for example, XSR links as described above and illustrated further below. However, the inclusion of SerDes interfaces 113 on laminate or substrate 103 in integrated circuit device 100 is optional, and some implementations of the subject matter of this disclosure may not include SerDes interfaces 113.

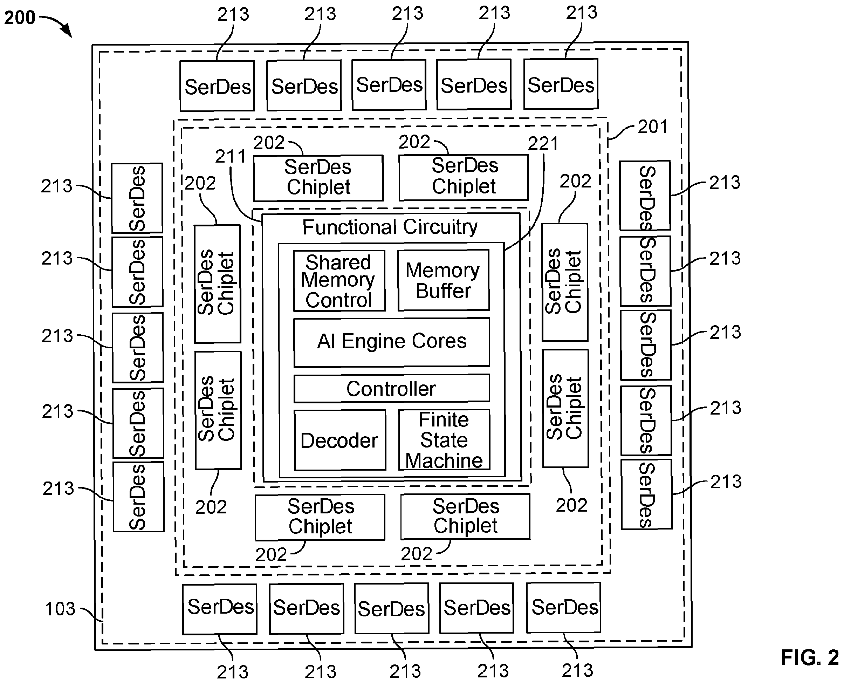

FIG. 2 shows a second implementation 200 of an integrated circuit device incorporating the subject matter of this disclosure. Integrated circuit device 200 includes a main integrated circuit die 201 incorporating functional circuitry 211. In this implementation, integrated circuit device 200 may be used for high-speed, high-data-bandwidth operations such as artificial intelligence processing, and therefore functional circuitry 211 may include artificial intelligence/machine learning (AI/ML) circuitry 121, which may include an AI controller and AI engine cores, supported by a decoder, one or more memory buffers, a shared memory controller, and one or more finite state machines. A "ring" of chiplets 202, incorporating high-speed SerDes interfaces, are mounted on the surface of main integrated circuit die 201 near the edge. As described below in connection with FIG. 9, metallization connections are provided that are configured to provide data from main integrated circuit die 201 to high-speed SerDes interfaces of chiplets 202. The high-speed SerDes interfaces of chiplets 202 may be configured to communicate data between integrated circuit device 200 and a remote integrated circuit device (not shown).

Main integrated circuit die 201 is mounted on a laminate or substrate 203. In the implementation shown, additional SerDes interfaces 213 are mounted in an additional ring on laminate or substrate 203. SerDes interfaces 213 may be lower-speed SerDes interfaces that may be coupled to portions of functional circuitry 201 using, for example, XSR links as described above and illustrated further below. However, the inclusion of SerDes interfaces 213 on laminate or substrate 203 in integrated circuit device 200 is optional, and some implementations of the subject matter of this disclosure may not include SerDes interfaces 213.

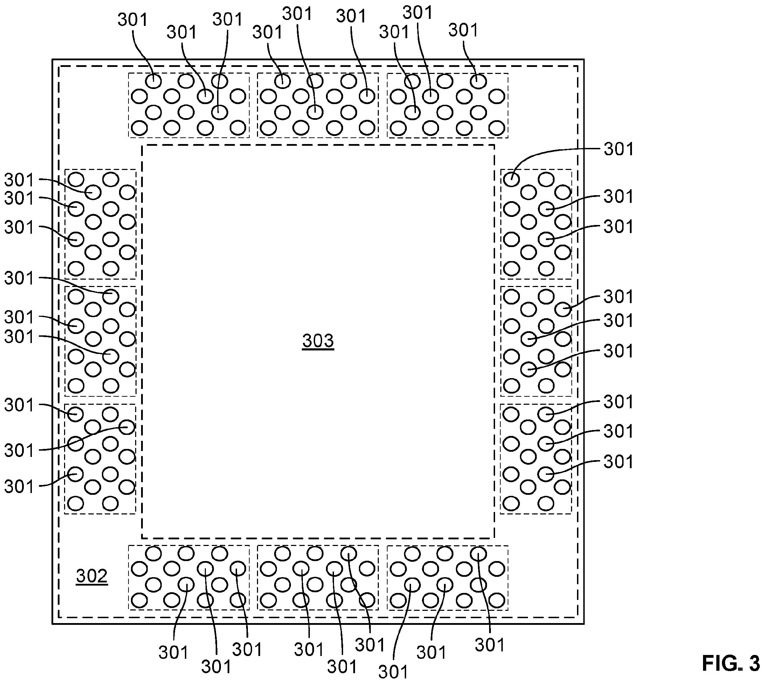

As illustrated in FIGS. 1 and 2, functional circuitry 111/211 occupies the portion of main integrated circuit die 101/201 that is not covered by SerDes chiplets 102/202. However, such a layout is shown for ease of illustration only, and there may be implementations of the subject matter of this disclosure in which functional circuitry 111/211 extends under SerDes chiplets 102/202 partway or even all of the way to the edge of main integrated circuit die 101/201. FIG. 3 shows how through-silicon vias (TSVs) 301 may be distributed on main integrated circuit die 101/201 to facilitate signaling between SerDes chiplets 102/202 and both functional circuitry 111/211 and terminals of integrated circuit device 100/200. In this implementation, TSVs 301 are provided in peripheral area 302 of main integrated circuit die 101/201, and are substantially uniformly spaced throughout peripheral area 302. As noted above, functional circuitry 111/211 may occupy the central area 303 bounded by peripheral area 302, or may extend into peripheral area 302. Even if functional circuitry 111/211 extend into peripheral area 302, there typically is sufficient unused area within the functional circuitry of an integrated circuit die for the passage of TSVs.

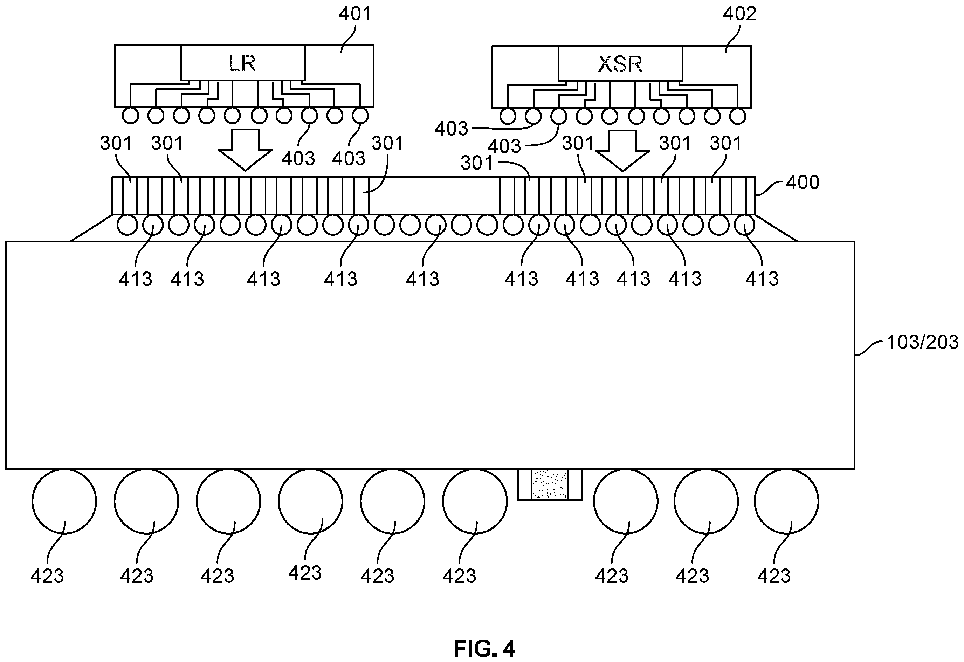

FIG. 4 shows one implementation of how SerDes chiplets may be mounted on an integrated circuit die 400 (such as main integrated circuit die 101/201). In this particular implementation, one of the SerDes chiplets is a long-reach serial interface chiplet 401, and another SerDes chiplet is an extremely short-reach serial interface chiplet 402. Each of SerDes chiplets 401, 402 is a bump array package having contact bumps 403 on one surface. In this implementation, each SerDes chiplet 401, 402 is mounted directly over a grouping of TSVs 301 in peripheral area 302, with each bump contact engaging a respective one of TSVs 301. In this cross-sectional view, the TSVs 301 can be seen extending through main integrated circuit die 400 from the top (in the orientation seen in the drawing) surface to the bottom surface. The bottom surface of main integrated circuit die 101/201 has its own array of contact bumps 413, which connect to conductive structures in laminate or substrate 103/203, as described below. Contact bumps 413 are encased in a material, such as, e.g., an epoxy material, that affixes main integrated circuit die 400 to laminate or substrate 103/203.

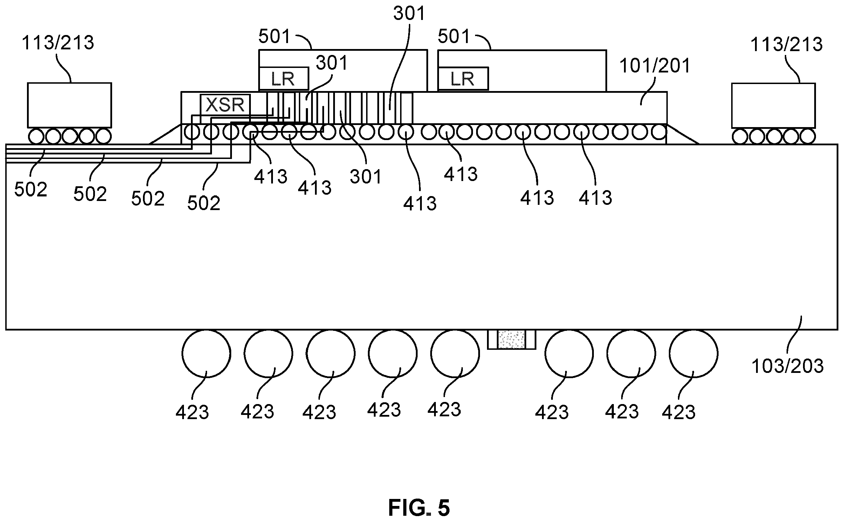

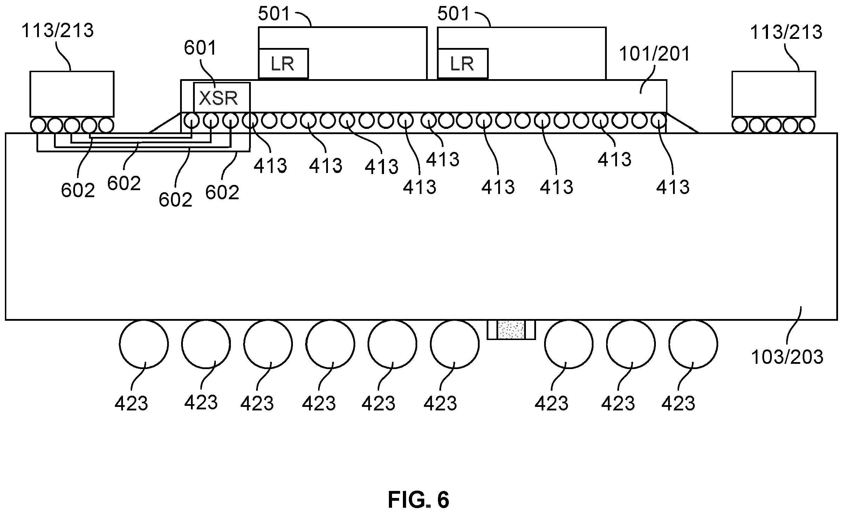

In the implementation of FIG. 4, there are no additional SerDes interfaces 113/213 on laminate or substrate 103/203. FIGS. 5 and 6 show implementations of the subject matter of this disclosure in which additional SerDes interfaces 113/213 are present on laminate or substrate 103/203.

In the implementation of FIG. 5, both of the SerDes chiplets 501 are long-reach serial interface chiplets. Signals from long-reach SerDes interfaces 501 are conducted along traces 502 through TSVs 301 (shown only under one of chiplets 501, but potentially present throughout peripheral area 302) to contact bumps 413 of main integrated circuit die 101/201 and then onto laminate or substrate 103/203 and on to (or from) their final destination. In this implementation, the SerDes interfaces 113/213 are present on laminate or substrate 103/203. As shown, traces 502 pass under one of SerDes interfaces 113/213. That particular one of SerDes interfaces 113/213, which is not coupled to main integrated circuit die 101/201 by traces 502, may be inactive, or may be coupled to other parts of main integrated circuit die 101/201 by other interconnections (not shown) to provide long-reach connectivity that supports other functionality of main integrated circuit die 101/201.

Conversely, in the implementation of FIG. 6, signals to or from circuitry of main integrated circuit die 101/201 are communicated by way of XSR transceiver circuitry 601, which may be built into main integrated circuit die 101/201, along traces 602 from contact bumps 413 to or from one or more of SerDes interfaces 113/213, which are active. SerDes chiplets 501 (which may again be long-reach serial interface chiplets) are not coupled to traces 602 and may be inactive, or may be coupled to other parts of main integrated circuit die 101/201 by other interconnections (not shown) to provide long-reach connectivity that supports other functionality of main integrated circuit die 101/201.

It is noted from the foregoing discussions of FIGS. 5 and 6 that configurations such as shown in FIGS. 5 and 6 may coexist within the same integrated circuit device.

In some arrangements such as those shown in FIGS. 5 and 6, SerDes interfaces 501 and 113/213 may be identical, while in other such arrangements SerDes interfaces 501 and 113/213 may be different from each other. For example, SerDes interfaces 501 on the main integrated circuit die 101/201 may be faster than the SerDes interfaces 113/213 in the outer ring on the laminate or substrate 103/203.

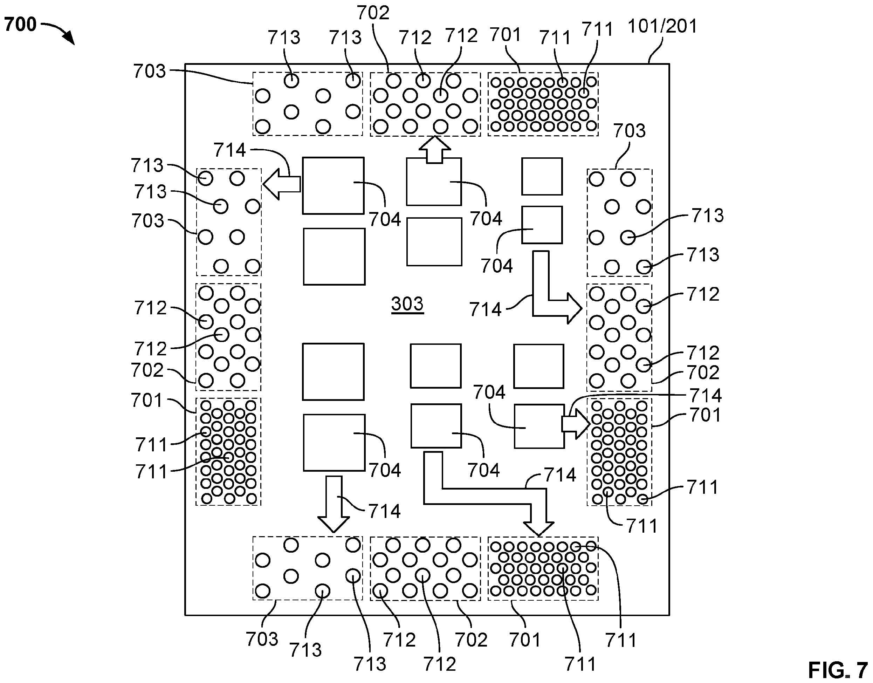

In the implementations shown in FIGS. 5 and 6, SerDes chiplets 501 are mounted directly above TSVs 301 (not shown in FIG. 6), so that the contacts of SerDes chiplets 501 make direct contact with TSVs 301 (as best seen in FIG. 5). However, in the implementation 700 shown in plan view in FIG. 7, SerDes chiplets 704 are mounted in the central area 303 of main integrated circuit die 101/201, and signals to or from SerDes chiplets 704 reach the TSVs along traces, symbolized by arrows 714, on the surface of main integrated circuit die 101/201. FIG. 7 also shows how the TSVs can be provided, in accordance with another aspect of this disclosure described above, with different areal density distributions in different regions. TSVs 711 in regions 701 have the highest areal density and therefore present the highest impedance and may be used for the slowest signals. TSVs 713 in regions 703 have the lowest areal density and therefore present the lowest impedance and may be used for the fastest signals. TSVs 712 in regions 702 have an intermediate density and therefore present intermediate impedance and may be used for the signals of intermediate speed. While the specific speeds supported by different TSV densities may be implementation dependent, in one implementation, for example, the low speed supported by region 701 may be below 56 Gbps, the intermediate speed supported by region 702 may be about 100 Gbps, and the high speed supported by region 703 may be between 200 Gbps and 224 Gbps (or higher).

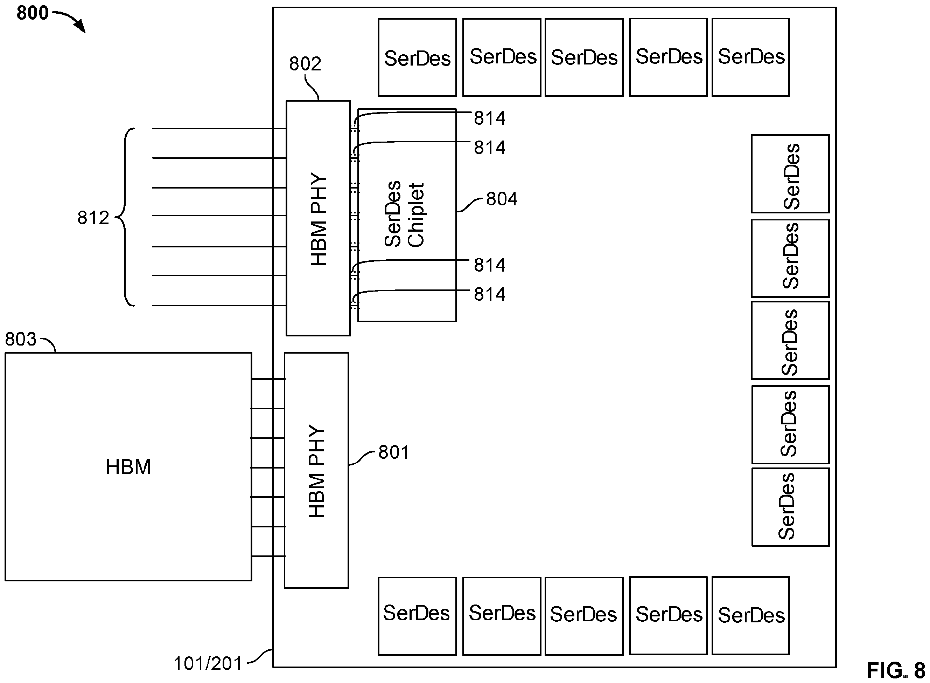

FIG. 8 illustrates another type of arrangement, as described above, in which there could be SerDes interfaces or other types of interfaces (e.g., physical layer transceivers) on the main die, coupled to input/output terminals (e.g., pins, pads or bumps) of the main die. The particular arrangement shown in FIG. 8 is a partial representation 800 of a high-bandwidth memory (HBM) system in which onboard HBM physical layer transceivers (PHYs) 801, 802 are provided. HBM PHY 801 is used for signaling between main die 101/201 and HBM circuitry 803. However, if in a particular application, as illustrated in FIG. 8, HBM PHY 802 is not used, the terminal connections 812 normally used by HBM PHY 802 may be accessed by a SerDes chiplet 804 by way of TSVs 814 that tunnel under HBM PHY 802 and intersect with terminal connections 812.

The discussion thus far has focused on the communication between SerDes chiplets on main integrated circuit die 101/201 and the terminals of main integrated circuit die 101/201, and connections between those terminals and signal traces on laminate or substrate 103/203 of integrated circuit device 100. However, the function of the SerDes interfaces of the SerDes chiplets is to couple functional circuitry of main integrated circuit die 101/201 to terminals of integrated circuit device 100 (and to devices outside integrated circuit device 100). FIG. 9 shows how such coupling may be achieved.

As seen in FIG. 9, a SerDes chiplet 901 is mounted on a surface of main integrated circuit die 101/201. Contact bumps 413 on an opposite surface of main integrated circuit die 101/201 couple to contacts (not shown) on a surface of laminate or substrate 103/203. Ball contacts 902 on an opposite surface of laminate or substrate 103/203 couple to contacts (not shown) of a printed circuit board 903.

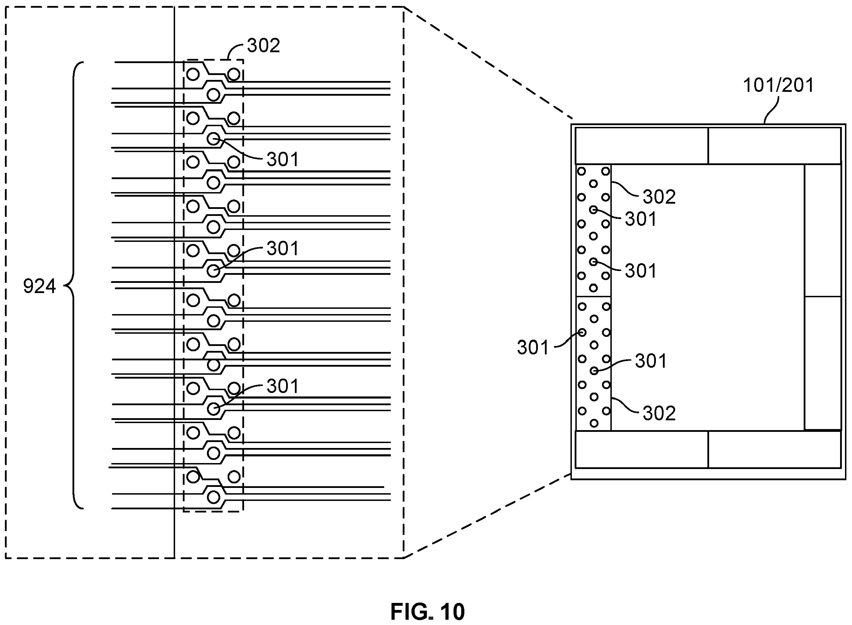

Transceiver 911 of SerDes chiplet 901 is coupled by pathway 904 by way of one of TSVs 301 to one of bump contacts 413. Pathway 904 continues through laminate or substrate 103/203 by way of a plated through-hole 905 to one of ball contacts 902 onto printed circuit board 903. Transceiver 911 thereby has access to devices outside integrated circuit device 100. Transceiver 911 also couples to circuitry within the interior layers of main integrated circuit die 101/201 by way of pathway 914, which extends through an additional TSV 924 that extends through the interior of main integrated circuit die 101/201, eventually extending parallel to the main surfaces of main integrated circuit die 101/201 and perpendicular to TSVs 301. As seen in FIG. 10 (which shows an integrated circuit die 101/201 with TSVs 301 in peripheral area 302, and an enlarged inset focused on peripheral area 302), there is space available for TSVs 924 to extend between and through TSVs 301. TSVs such as TSVs 924, which extend through the interior of main integrated circuit die 101/201, allow coupling of SerDes 911, which may be, e.g., an XSR SerDes, to the functional circuitry of main integrated circuit die 101/201 through such a short path that filtering and equalization circuitry may not be necessary (at least on the side of SerDes 911 that interfaces with the functional circuitry), considerably reducing power consumption relative to SerDes configurations that require signal filtering and equalization.

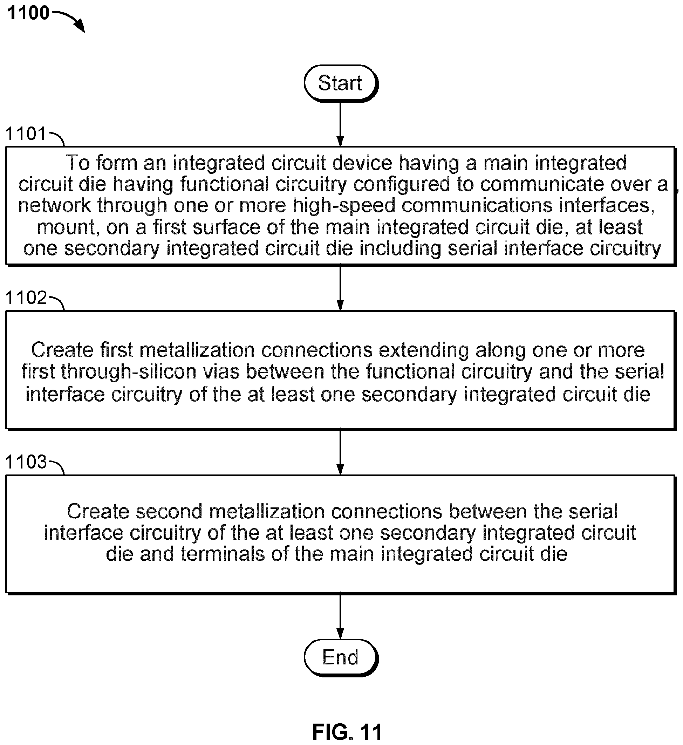

A method 1100 in accordance with the subject matter of this disclosure, for forming an integrated circuit device having a main integrated circuit die having functional circuitry including network switch circuitry, is diagrammed in FIG. 11. Method 1100 begins at 1101, where at least one secondary integrated circuit die, including serial interface circuitry, is mounted on a first surface of the main integrated circuit die. At 1102, first metallization connections are created between the functional circuitry and the serial interface circuitry of the at least one secondary integrated circuit die. At 1103, second metallization connections are created between the serial interface circuitry of the at least one secondary integrated circuit die and terminals of the main integrated circuit die. Method 1100 then ends.

Thus it is seen that a method for creating integrated circuit device packages in which serializer/deserializer (SerDes) chiplets are stacked on the main integrated circuit die, and integrated circuit device packages thus created, have been provided.

As used herein and in the claims which follow, the construction "one of A and B" shall mean "A or B."

It is noted that the foregoing is only illustrative of the principles of the invention, and that the invention can be practiced by other than the described embodiments, which are presented for purposes of illustration and not of limitation, and the present invention is limited only by the claims which follow.

## Claims

1. An integrated circuit device comprising:
a main integrated circuit die having functional circuitry configured to communicate over a network through one or more high-speed communications interfaces;
at least one secondary integrated circuit die including serial interface circuitry, each secondary integrated circuit die among the at least one secondary integrated circuit die being mounted on a first surface of the main integrated circuit die; and
first metallization connections extending along one or more first through-silicon vias between the functional circuitry and the serial interface circuitry of the at least one secondary integrated circuit die.

2. The integrated circuit device of claim 1 wherein:
the first metallization connections are configured to provide data from the main integrated circuit die to the secondary integrated circuit die; and
the secondary integrated circuit die is configured to communicate data between the integrated circuit device and a remote integrated circuit device.

3. The integrated circuit device of claim 1 further comprising second metallization connections between the serial interface circuitry of the at least one secondary integrated circuit die and terminals of the main integrated circuit die.

4. The integrated circuit device of claim 3 wherein:
at least one metallization connection among the first metallization connections extends along a respective one of the first through-silicon vias between (a) elements of the functional circuitry within layers of the main integrated circuit die, and (b) the first surface of the main integrated circuit die; and optionally
at least one metallization connection among the second metallization connections extends along at least one respective second through-silicon via between (a) the first surface of the main integrated circuit die, and (b) at least one respective terminal of the main integrated circuit die, the at least one respective second through-silicon via being perpendicular to the first surface of the main integrated circuit die; and further optionally
the at least one metallization connection among the first metallization connections extends along a respective first through-silicon via, parallel to the first surface of the main integrated circuit die, between respective ones of the at least one second through-silicon via, to reach the functional circuitry.

5. The integrated circuit device of claim 3 wherein at least one metallization connection among the second metallization connections extends along at least one respective second through-silicon via between (a) the first surface of the main integrated circuit die, and (b) at least one respective terminal of the main integrated circuit die.

6. The integrated circuit device of claim 5 wherein the respective one of the terminals of the main integrated circuit die is on a second surface of the main integrated circuit die opposite the first surface of the main integrated circuit die.

7. The integrated circuit device of claim 5 wherein:
the at least one secondary integrated circuit die is mounted on the first surface of the main integrated circuit die in a contact relationship with the respective second through-silicon via; and optionally
the at least one metallization connection among the second metallization connections extends from the serial interface circuitry of the at least one secondary integrated circuit die along the respective second through-silicon via between (a) the first surface of the main integrated circuit die, and (b) the at least one respective terminal of the main integrated circuit die, without any external connection channel extending between the serial interface circuitry of the at least one secondary integrated circuit die and the at least one respective terminal.

8. The integrated circuit device of claim 5 wherein:
the at least one secondary integrated circuit die is mounted on the first surface of the main integrated circuit die at a distance from the respective second through-silicon via; and
the at least one metallization connection among the second metallization connections includes a metallization trace from the at least one secondary integrated circuit die to the respective second through-silicon via; or
the main integrated circuit die has a plurality of the respective second through-silicon vias;
second through-silicon vias in the plurality of the respective second through-silicon vias are grouped into respective zones, the second through-silicon vias being distributed at different areal densities in different zones;
the at least one secondary integrated circuit die including serial interface circuitry includes a plurality of respective integrated circuit dies each having respective serial interface circuitry of different respective maximum speeds; and
respective ones of the second metallization connections couple the respective serial interface circuitry of each respective secondary integrated circuit die of the plurality of secondary integrated circuit dies to at least one of the second through-silicon vias in one of the respective zones according to the respective maximum speed of the respective serial interface circuitry; or
the main integrated circuit die further comprises additional interface circuitry coupled to particular terminals of the main integrated circuit die;
the at least one metallization connection among the second metallization connections, that extends along the at least one respective second through-silicon via between (a) the first surface of the main integrated circuit die, and (b) the at least one respective terminal of the main integrated circuit die, extends along the at least one respective second through-silicon via between (a) the first surface of the main integrated circuit die, and (b) the particular terminals of the main integrated circuit die; and
when the additional interface circuitry is not being used, the second metallization connections are used to connect the at least one secondary integrated circuit die through the at least one respective second through-silicon via to the particular terminals of the main integrated circuit die.

9. A method of forming an integrated circuit device having a main integrated circuit die having functional circuitry configured to communicate over a network through one or more high-speed communications interfaces, the method comprising:
mounting, on a first surface of the main integrated circuit die, at least one secondary integrated circuit die including serial interface circuitry; and
creating first metallization connections extending along one or more first through-silicon vias between the functional circuitry and the serial interface circuitry of the at least one secondary integrated circuit die.

10. The method according to claim 9 of forming an integrated circuit device, the method further comprising:
configuring the first metallization connections to provide data from the main integrated circuit die to the secondary integrated circuit die; and
configuring the secondary integrated circuit die to communicate data between the integrated circuit device and a remote integrated circuit device.

11. The method according to claim 9 of forming an integrated circuit device, the method further comprising creating second metallization connections between the serial interface circuitry of the at least one secondary integrated circuit die and terminals of the main integrated circuit die.

12. The method of forming an integrated circuit device according to claim 11, wherein:
creating the first metallization connections comprises creating at least one metallization connection among the first metallization connections extending along a respective of the first through-silicon vias between (a) elements of the functional circuitry within layers of the main integrated circuit die, and (b) the first surface of the main integrated circuit die; and optionally
creating the second metallization connections comprises creating at least one metallization connection among the second metallization connections extending along at least one respective second through-silicon via between (a) the first surface of the main integrated circuit die, and (b) at least one respective terminal of the main integrated circuit die, the at least one respective second through-silicon via being perpendicular to the first surface of the main integrated circuit die; and further optionally
creating the first metallization connections comprises creating at least one metallization connection among the first metallization connections that extends along a respective first through-silicon via, parallel to the first surface of the main integrated circuit die, between respective ones of the at least one second through-silicon via, to reach the functional circuitry.

13. The method of forming an integrated circuit device according to claim 11 wherein creating the second metallization connections comprises creating at least one metallization connection among the second metallization connections extending along at least one respective second through-silicon via between (a) the first surface of the main integrated circuit die, and (b) at least one respective terminal of the main integrated circuit die.

14. The method of forming an integrated circuit device according to claim 13 wherein:
creating the at least one metallization connection among the second metallization connections extending along the at least one respective second through-silicon via between (a) the first surface of the main integrated circuit die, and (b) at least one respective terminal of the main integrated circuit die comprises creating the at least one metallization connection among the second metallization connections extending along the at least one respective second through-silicon via between (a) the first surface of the main integrated circuit die, and (b) at least one respective terminal of the main integrated circuit die on a second surface of the main integrated circuit die opposite the first surface of the main integrated circuit die; or
mounting, on the first surface of the main integrated circuit die, the at least one secondary integrated circuit die including serial interface circuitry, comprises mounting the at least one secondary integrated circuit die on the first surface of the main integrated circuit die at a distance from the respective second through-silicon via; the method further comprising:
creating a metallization trace from the at least one secondary integrated circuit die to the respective second through-silicon via; or
mounting, on the first surface of the main integrated circuit die, the at least one secondary integrated circuit die including serial interface circuitry, includes mounting a plurality of respective integrated circuit dies each having respective serial interface circuitry of different respective maximum speeds; the method further comprising:
forming a plurality of the respective through-silicon vias in the main integrated circuit die;
grouping second through-silicon vias in the plurality of the respective second through-silicon vias into respective zones, and distributing the second through-silicon vias at different areal densities in different zones; and
coupling the respective serial interface circuitry of each respective secondary integrated circuit die of the plurality of secondary integrated circuit dies to at least one of the second through-silicon vias in one of the respective zones according to the respective maximum speed of the respective serial interface circuitry; or
when the main integrated circuit die further comprises additional interface circuitry coupled to particular terminals of the main integrated circuit die, forming the at least one metallization connection among the second metallization connections, that extends along the at least one respective second through-silicon via between (a) the first surface of the main integrated circuit die, and (b) the at least one respective terminal of the main integrated circuit die, comprises forming the at least one metallization connection among the second metallization connections to extend along the at least one respective second through-silicon via between (a) the first surface of the main integrated circuit die, and (b) the particular terminals of the main integrated circuit die; and
when the additional interface circuitry is not being used, using the second metallization connections to connect the at least one secondary integrated circuit die through the at least one respective second through-silicon via to the particular terminals of the main integrated circuit die.

15. The method of forming an integrated circuit device according to claim 13 wherein:
mounting, on the first surface of the main integrated circuit die, the at least one secondary integrated circuit die including serial interface circuitry, comprises mounting the at least one secondary integrated circuit die on the first surface of the main integrated circuit die in a contact relationship with the respective second through-silicon via; and optionally
creating the at least one metallization connection among the second metallization connections extending from the serial interface circuitry of the at least one secondary integrated circuit die along the respective second through-silicon via between (a) the first surface of the main integrated circuit die, and (b) the at least one respective terminal of the main integrated circuit die, comprises creating the at least one metallization connection among the second metallization connections extending from the serial interface circuitry of the at least one secondary integrated circuit die along the respective second through-silicon via between (a) the first surface of the main integrated circuit die, and (b) the at least one respective terminal of the main integrated circuit die without creating any external connection channel extending between the serial interface circuitry of the at least one secondary integrated circuit die and the at least one respective terminal.
